# FASCICULE DE BREVET EUROPEEN

(11) **EP 0 489 666 B1**
(45) Date de publication et mention de la délivrance du brevet: **09.08.1995**
(21) Numéro de dépôt: 91420421.9
(22) Date de dépôt: 27.11.1991
(51) Int. Cl.: H01R 13/453, H01R 11/18, G01R 1/04, H01R 13/53, H01R 13/625

(54) **Ensemble de connexion avec une prise test**
Verbindungseinrichtung mit Prüfstecker
Connection set with test plug

(30) Priorité: 06.12.1990 FR 9015402
(43) Date de publication de la demande: 10.06.1992
(73) Titulaire: SCHNEIDER ELECTRIC SA, 92100 Boulogne Billancourt (FR)
(72) Inventeur: Davin, Paul, F-38050 Grenoble Cédex 9 (FR); Negrello, Frédéric, F-38050 Grenoble Cédex 9 (FR); Corcoles, Vincent, F-38050 Grenoble Cédex 9 (FR)
(74) Mandataire: Jouvray, Marie-Andrée

(56) Documents cités:
- EP-A- 0 326 098
- DE-A- 3 000 434
- DE-A- 3 108 523
- DE-U- 9 005 156
- FR-A- 2 179 782
- US-A- 4 531 800

## Description

L'invention concerne un ensemble de connexion pour le test d'un déclencheur électronique.

Dans les déclencheurs classiques, le test du déclencheur s'effectue après connexion de deux entrées test à un coffret test comportant une source de tension ou de courant. La connexion est normalement réalisée au moyen d'un connecteur mâle solidaire du déclencheur sur lequel vient se connecter un connecteur femelle, relié par un câble au coffret-test. Le connecteur mâle comporte deux broches dont l'extrémité arrive sensiblement au ras de la face avant du déclencheur.

Avec ce type de connexion, il est difficile d'isoler correctement les entrées test vis à vis de la face avant. De plus le connecteur femelle, de faibles dimensions, est peut maniable.

L'invention a pour objet un ensemble de connexion avec une prise test permettant de remédier à ces inconvénients.

Dans certaines prises de sécurité des ensembles de connexion (FR-A-2.179.782 décrivant un ensemble de connexion selon le préambule de la revendication 1; DE-A-3.000.434) les contacts sont, en position déconnectée, protégés, au moins partiellement, par un élément mobile coulissant axialement, sous l'action d'un ressort, par rapport au corps de la prise.

Selon l'invention, l'ensemble de connexion comporte une prise et des éléments de connexion complémentaires destinés à coopérer avec la prise en position connectée, la prise comportant un élément fixe en matériau isolant, deux contacts solidaires de l'élément fixe et connectés par une première extrémité à des conducteurs, un élément mobile en matériau isolant comportant des passages pour les contacts et pouvant se déplacer axialement à l'intérieur de l'élément fixe, un organe élastique sollicitant axialement l'élément mobile vers l'extérieur de l'élément fixe de manière à ce qu'une partie de l'élément mobile fasse saillie à l'extrémité de l'élément fixe, l'élément mobile comportant un épaulement d'appui prenant appui, en position connectée, sur une paroi complémentaire isolante de manière à comprimer l'organe élastique et à déplacer axialement l'élément mobile vers l'intérieur de l'élément fixe. Il est caractérisé en ce que :
- les éléments de connexion complémentaires comportent des pastilles conductrices formées sur un circuit imprimé, le circuit imprimé étant disposé à l'intérieur d'un déclencheur électronique, derrière ladite paroi complémentaire,
- les pastilles constituent des entrées test permettant le test du déclencheur lorsque, en position connectée de l'ensemble de connexion, une source d'énergie, connectée auxdits conducteurs fournit une tension ou un courant de test,
- la paroi complémentaire comporte deux orifices fins et est disposée en retrait vers l'intérieur du déclencheur par rapport à la paroi externe d'une face du déclencheur, à laquelle elle est reliée par des parois latérales,
- les contacts de la prise sont constitués par des aiguilles de test comportant des extrémités libres effilées,
- les extrémités libres des aiguilles de test sont, en position déconnectée de la prise, logées en totalité à l'intérieur de passages longitudinaux traversant l'élément mobile,
- en position connectée de la prise, les extrémités libres des aiguilles de test font saillie à l'extrémité de l'élément mobile , traversent les orifices de la paroi complémentaire et viennent en contact, par aboutement, avec les pastilles conductrices,
- la prise comporte des moyens de verrouillage coopérant, en position connectée, avec des moyens de verrouillage complémentaires de ladite face du déclencheur.

Le contact électrique entre les parties mâle et femelle du connecteur, c'est à dire entre les aiguilles de test de la prise test et les pastilles du circuit imprimé du déclencheur, s'effectue obligatoirement en retrait par rapport à la face du déclencheur. Il est ainsi possible d'obtenir un très bon isolement vis à vis de la face avant, en pratique supérieur à 12kV, et de limiter au maximum les problèmes de décharges électrostatiques. De plus, un utilisateur ne risque pas de venir toucher accidentellement une partie sous tension du déclencheur électronique, le seul passage vers la carte du circuit imprimé étant constitué par des orifices de très petites dimensions, destinés uniquement au passage des aiguilles de test. A titre d'exemple le diamètre de ces orifices est inférieur à 1mm. Il est à noter que le coût de la partie femelle, constituée par deux pastilles sur un circuit imprimé, est négligeable. De plus, en position non connectée les aiguilles sont rentrées à l'intérieur de la partie mobile. Il y a donc protection du manipulateur par rapport à un contact direct avec les aiguilles mises sous tension (tenue 1,5KV).

Selon un développement de l'invention, ledit épaulement d'appui est constitué par la face supérieure de l'élément mobile, lesdits orifices étant de forme conique et formés dans ladite paroi complémentaire de la face du déclencheur. L'utilisation des orifices coniques facilite le guidage des aiguilles lors de la connexion.

La prise test comporte, de préférence, des moyens de limitation du déplacement axial de l'élément mobile vis à vis de l'élément fixe sous l'action de l'organe élastique. Ces moyens peuvent comporter au moins une gorge longitudinale formée dans l'élément mobile et comportant à sa partie inférieure un épaulement, un organe de butée complémentaire étant solidaire de l'élément fixe.

Les moyens de verrouillage comportent, de préférence, au moins un crochet de verrouillage solidaire d'une gaine, en matériau isolant, entourant l'élément fixe, le crochet et la gaine étant susceptibles d'effectuer une rotation limitée par rapport aux éléments fixe et mobile, une partie du crochet venant, en position de verrouillage, se verrouiller sur un épaulement de verrouillage complémentaire de la face du déclencheur.

Selon un mode de réalisation préféré, l'élément mobile comporte au moins une gorge de logement du crochet de verrouillage en position déverrouillée.

D'autres avantages et caractéristiques ressortiront plus clairement de l'exposé qui va suivre d'un mode de réalisation particulier de l'invention, donné à titre d'exemple non limitatif et représenté aux dessins annexés sur lesquels :

Les figures 1 et 2 représentent en coupe, une prise test respectivement déconnectée et en position de connexion avec la face avant d'un déclencheur.

La figure 3 illustre une aiguille de test de la prise test selon les figures 1 et 2.

La figure 4 représente, en coupe selon AA (figure 1), la gaine de la prise test selon les figures 1 et 2.

Les figures 5 et 6 représentent l'élément fixe de la prise test, respectivement en coupe selon BB (figure 6) et en vue de dessus.

La figure 7 illustre un crochet de verrouillage, la figure 8 étant une vue latérale droite du crochet de la figure 7.

Les figures 9 et 10 représentent les positions respectives de l'élément mobile de la prise test et d'un crochet de verrouillage, respectivement en position déconnectée et en position de verrouillage.

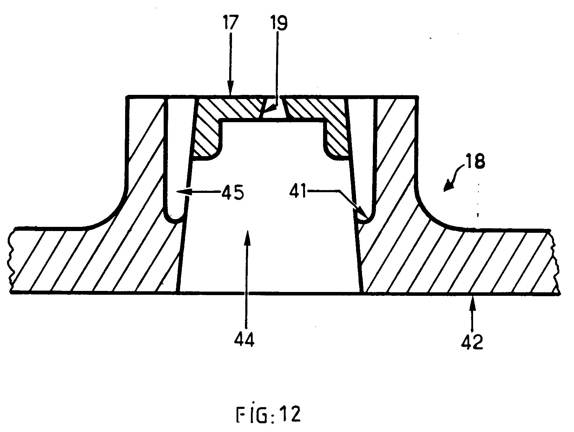

La figure 11 est une coupe, selon CC (figure 9), de l'élément mobile.

La figure 12 est une coupe selon DD (figure 2) de la face avant d'un déclencheur sur lequel la prise test est destinée à être connectée.

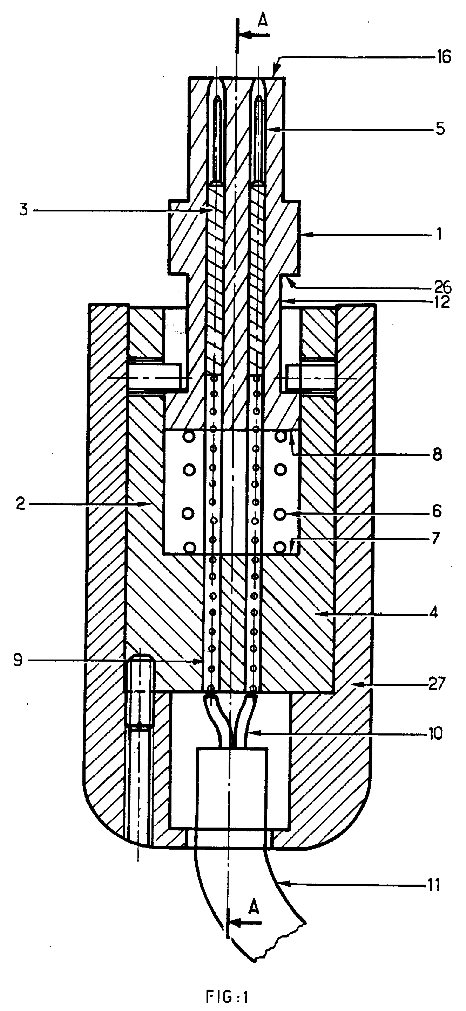

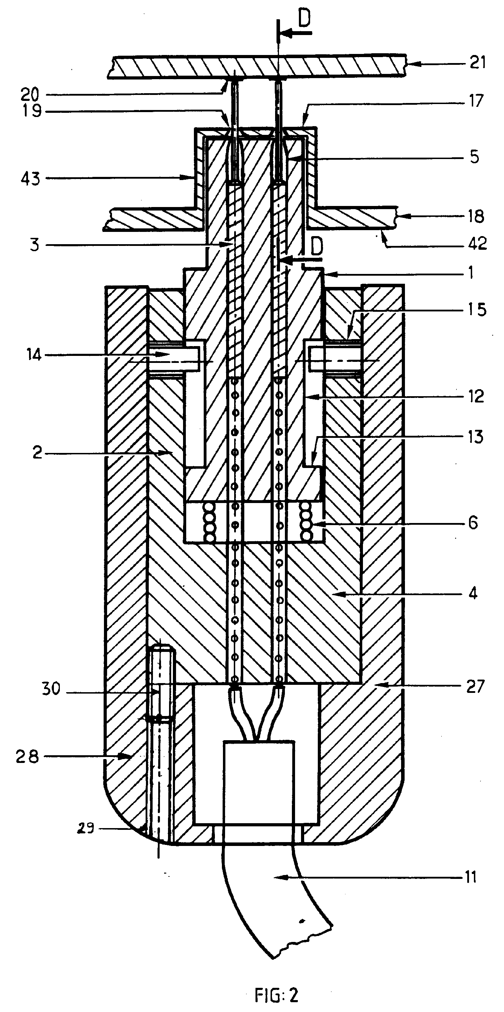

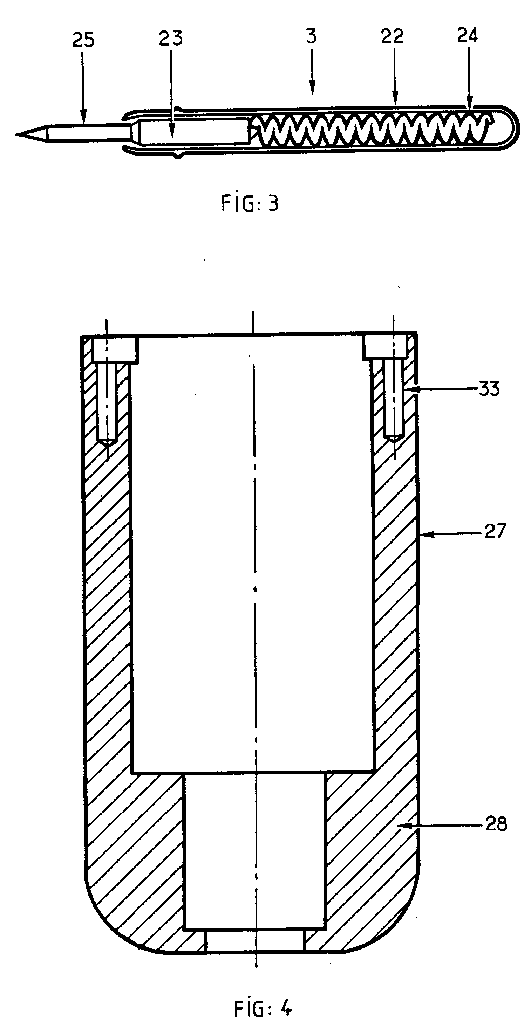

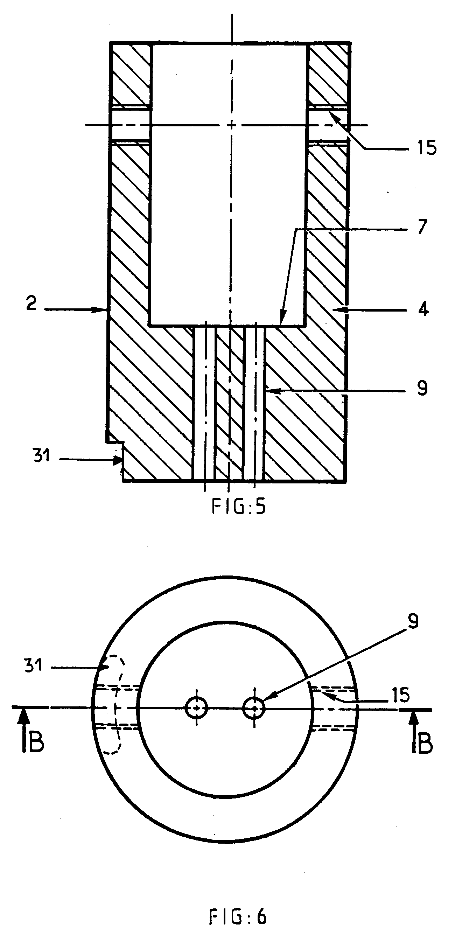

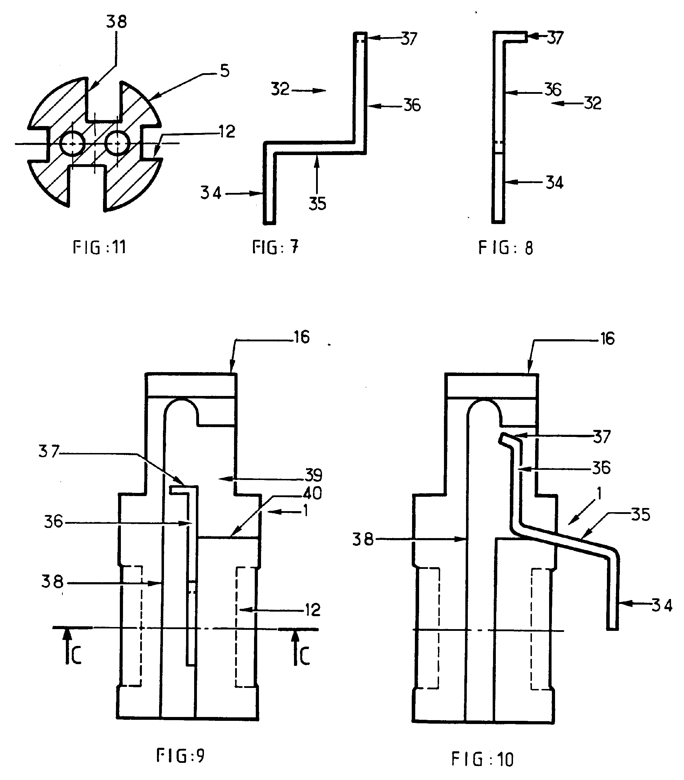

La prise test, illustrée sur les figures 1 et 2, comporte un élément mobile 1 pouvant coulisser axialement à l'intérieur d'un élément fixe 2, en forme de douille,dans lequel il est inséré par sa partie inférieure. Deux aiguilles de test 3, solidaires de la base 4 de l'élément fixe 2, sont engagées dans des passages longitudinaux 5, parallèles, traversant l'élément mobile 1. Un ressort de compression 6, disposé axialement entre la paroi supérieure 7 de la base de l'élement fixe 2 et la paroi inférieure 8 de l'élément mobile 1, sollicite normalement l'élément mobile 1 à l'écart de la base 4 de l'élément fixe 2.

Les aiguilles de test 3 sont fixées par tout moyen approprié à la base 4 de l'élément fixe 2. Dans le mode de réalisation représenté, la partie inférieure d'une aiguille est collée dans un passage cylindrique 9 traversant longitudinalement la base 4. L'extrémité inférieure de chaque aiguille est connectée électriquement, par exemple par soudage, à un conducteur 10 d'un câble 11 destiné à relier la prise test à un dispositif de test (non représenté) fournissant un courant ou une tension de test.

L'élément mobile 1 comporte sur sa paroi externe au moins une gorge longitudinale 12 formant à sa partie inférieure un épaulement 13. Lorsque la prise test n'est pas connectée (figure 1), l'épaulement 13 vient buter sur un organe de butée 14, solidaire de l'élément fixe 2, et faisant saillie transversalement vers l'intérieur de celui-ci. Dans le mode de réalisation représenté, l'élément mobile comporte deux gorges 12 symétriques, associées à deux organes de butée 14, constitués par des vis. Les vis 14 sont vissées dans des orifices taraudés transversaux 15 formés dans la paroi latérale de l'élément fixe 2. En position déconnectée, le déplacement axial de l'élément fixe 1, sous l'action du ressort 6, est limité par la venue en butée des épaulements 13 de l'élément mobile 1 sur les vis 14 solidaires de l'élément fixe 2.

Les dimensions respectives des différents éléments sont telles qu'en position déconnectée, les extrémités supérieures des aiguilles 3 sont logées en totalité à l'intérieur des passages 5. Par contre (figure 2), lorsque la face supérieure 16 de l'élément mobile 1 vient en contact avec une paroi 17, isolante, de la face avant 18 d'un déclencheur à tester, le ressort 6 est comprimé et l'élément mobile 1 se déplace axialement en direction de la paroi supérieure 7 de la base 4 de l'élément fixe 2. Les extrémités supérieures des aiguilles 3 font alors saillie hors des passages 5 et traversent la paroi 17 par des orifices 19 pour venir en contact avec des pastilles 20 d'un circuit imprimé 21 du déclencheur. La prise test constitue ainsi la partie mâle du connecteur, dont la partie femelle, très simple, est constituée par deux pastilles 20 du circuit imprimé 21 du déclencheur à tester.

Les orifices 19 de la paroi 17 de la face avant du déclencheur sont de préférence coniques, l'extrémité étroite des cones étant disposée à l'intérieur, de manière à servir d'élément de guidage pour les extrémités supérieures des aiguilles 3.

Les aiguilles de test 3 sont des aiguilles de test classiques, disponibles dans le commerce,par exemple du type illustré sur la figure 3. Chaque aiguille 3 comporte un corps 22 dans lequel un élément 23, formant un piston, est sollicité vers l'extérieur sous l'action d'un ressort de compression 24. Une partie effilée 25, solidaire du piston 23, forme l'extrémité supérieure de l'aiguille et fait saillie hors du corps 22.

Les dimensions des divers éléments sont tels que, lorsque la prise test est connectée, la course maximale de l'élément mobile 1 vis à vis de l'élément fixe 2 est légèrement supérieure à la distance entre la face extérieure de la paroi 17 et la face du circuit imprimé 21 portant les pastilles 20. Ainsi, lors de la connexion, la venue en contact de l'extrémité supérieure d'une aiguille 3 avec une pastille 20 entraîne la compression du ressort 24 de l'aiguille. Ceci assure un bon contact entre les parties mâles et femelle de la connexion, et chaque aiguille comportant son propre ressort, permet de rattraper les tolérances des divers constituants du connecteur.

La course maximale de la partie mobile vis à vis de la partie fixe peut être définie par un épaulement 26 délimitant la partie supérieure de la gorge 12. La venue en butée de l'épaulement 26 et d'un organe de butée 14, qui est de préférence le même que précédemment, définit cette course maximale.

La prise test comporte, de plus, des moyens de verrouillage destinés à coopérer avec des moyens complémentaires de la face avant 18 du déclencheur à tester.

Dans le mode de réalisation représenté sur les figures, la prise test comporte une gaine externe 27, de forme générale cylindrique, dans laquelle l'élément fixe 2, également de forme cylindrique, est introduit axialement. La gaine est solidaire, axialement, de l'élément fixe, mais peut effectuer une rotation limitée autour de leur axe commun. La face inférieure de la base 4 de l'élément fixe vient en contact avec la face supérieure de la base 28 de la gaine. Cette base 28 comporte un passage pour le câble 11. Un dispositif mécanique est prévu pour limiter la rotation de la gaine 27 par rapport à l'élément fixe 2, et éviter ainsi la détérioration des crochets de verrouillage. Dans le mode de réalisation préférentiel représenté sur les figures, la base 28 de la gaine comporte un orifice longitudinal 29 dans lequel est disposée une butée 30 qui fait saillie vers l'intérieur et qui coopère avec une gorge 31 de l'élément fixe. Les dimensions de la gorge 31 fixent l'angle de rotation maximum de la gaine vis à vis de l'élément fixe. Cet angle est par exemple voisin de 30°.

Au moins un crochet de verrouillage 32 est solidaire de la gaine 27. Une première extrémité 34 du crochet est fixée dans un orifice longitudinal 33 formé à la partie supérieure de la paroi latérale de la gaine 27. Dans le mode de réalisation représenté à la figure 4, la gaine 27 comporte deux orifices 33 symétriques par rapport à son axe, destinés à la fixation, par tout moyen approprié, de deux crochets de verrouillage 32.

Le crochet 32 (figures 7 et 8) comporte quatre parties, 34 à 37, formant deux équerres. Les trois premières parties 34 à 36 sont parallèles et connectées par une partie 35 qui leur est perpendiculaire.

L'extrémité 34 du crochet étant fixée dans l'orifice longitudinal 33 de la gaine, la partie 35 est parallèle à la face supérieure de l'élément fixe 2 et peut être utilisée pour le maintien axial de celui-ci à l'intérieur de la gaine 27.

En position déconnectée, les parties 35 et 36 du crochet de verrouillage 32 sont engagées dans une gorge longitudinale 38 de l'élément mobile 1, comme représenté à la figure 9. La partie 35 est parallèle à la face supérieure de l'élément fixe 2 et la partie 34 est fixée dans un orifice 33 de la gaine 27.

La gorge 38 débouche dans une partie évidée 39 de l'élément mobile 1, comportant un épaulement inférieur 40. Lorsque la prise test est connectée, le crochet 32 est amené en position de verrouillage par rotation de la gaine 27 vis à vis des éléments fixe et mobile. L'élément mobile 1 est solidarisé en rotation avec l'élément fixe par l'intermédiaire des butées 14 et des gorges 12. Les positions relatives du crochet 32 et de l'élément mobile en position de verrouillage sont représentées à la figure 10. L'élément mobile s'est déplacé axialement vers le bas par rapport à l'élément fixe et à la gaine, dont le crochet 32 est solidaire par sa partie 34. La partie 35 passe au-dessus du plan de l'épaulement 40 et vient prendre appui sur celui-ci après rotation de la gaine 27. La partie 37, parallèle au plan de la figure dans la figure 9, a effectué une rotation par rapport à ce plan et fait saillie par rapport au plan de la figure 10. Cette partie 37 peut, dans cette position, venir se verrouiller sur un épaulement de verrouillage complémentaire 41 de la face avant du déclencheur,assurant ainsi le verrouillage de la prise test sur celle-ci.

La figure 12 illustre plus en détail la partie de la face avant 18 d'un déclencheur destiné à coopérer avec la prise test décrite ci-dessus.

La paroi 17 de la face avant 18 du déclencheur, contre laquelle vient s'appuyer la face supérieure de la partie mobile 1 lors de la connexion, est disposée en retrait par rapport à la paroi frontale 42 de la face avant 18 à laquelle elle est reliée par des parois latérales 43 (figure 2), de manière à former une cavité 44 dans laquelle est introduite l'extrémité supérieure de l'élément mobile. La cavité, non cylindrique, a une forme complémentaire de celle de la partie supérieure de l'élément mobile. Des évidements 45 sont formés dans au moins une paroi latérale de la cavité 44. Dans le mode de réalisation représenté, deux évidements 45 sont prévus dans deux parois opposées, pour coopérer avec deux crochets de verrouillage 32 de la prise test. Chaque évidement comporte un épaulement de verrouillage 41 derrière lequel la partie 37 du crochet associé vient se placer lorsque la prise test est verrouillée.

La connexion s'effectue donc très simplement, d'abord par appui de la face supérieure de la partie mobile sur la paroi 17, en retrait, de la face avant du déclencheur. Ensuite, l'élément mobile étant maintenu dans la cavité 44, non cylindrique, de la face avant, un mouvement de rotation, d'environ 30°, de la gaine vis à vis des éléments fixe et mobile, a pour effet de libérer les deux crochets de verrouillage qui viennent se placer derrière les épaulements de verrouillage 41. La déconnexion s'effectue par une rotation en sens inverse, réalisant le déverrouillage, la partie fixe étant ensuite retirée de la cavité 44 de la face avant.

L'invention n'est pas limitée au mode de réalisation particulier représenté sur les figures. En particulier, d'autres moyens de verrouillage peuvent être prévus, par exemple un verrouillage par frottement entre l'élément mobile et une partie complémentaire de la face avant. De même, bien qu'il soit préférable que ce soit le contact entre la face supérieure de l'élément mobile et la paroi (17) qui provoque la compression du ressort (6), et le déplacement de la partie mobile, ce résultat peut être obtenu par d'autres moyens, notamment par le contact entre un épaulement d'appui de la partie mobile et une paroi complémentaire de la face avant. Les éléments fixe et mobile, de forme générale cylindriques, ainsi que la gaine sont bien entendu en matériau isolant. La gaine, en matériau usiné, peut être de dimension suffisante pour permettre une bonne tenue en main de la prise test.

## Revendications

1. Ensemble de connexion comportant une prise et des éléments de connexion complémentaires destinés à coopérer avec la prise en position connectée, la prise comportant un élément fixe (2) en matériau isolant, deux contacts solidaires de l'élément fixe (2) et connectés par une première extrémité à des conducteurs (10), un élément mobile (1) en matériau isolant comportant des passages (5) pour les contacts et pouvant se déplacer axialement à l'intérieur de l'élément fixe (2), un organe élastique (6) sollicitant axialement l'élément mobile (1) vers l'extérieur de l'élément fixe (2) de manière à ce qu'une partie de l'élément mobile (1) fasse saillie à l'extrémité de l'élément fixe (2), l'élément mobile (1) comportant un épaulement d'appui (16) prenant appui, en position connectée, sur une paroi complémentaire isolante (17) de manière à comprimer l'organe élastique (6) et à déplacer axialement l'élément mobile (1) vers l'intérieur de l'élément fixe (2), ensemble
caractérisé en ce que :
- les éléments de connexion complémentaires comportent des pastilles conductrices (20) formées sur un circuit imprimé (21), le circuit imprimé étant disposé à l'intérieur d'un déclencheur électronique, derrière ladite paroi complémentaire (17),
- les pastilles (20) constituent des entrées test permettant le test du déclencheur lorsque, en position connectée de l'ensemble de connexion, une source d'énergie, connectée auxdits conducteurs (10) fournit une tension ou un courant de test,
- la paroi complémentaire (17) comporte deux orifices fins (19) et est disposée en retrait vers l'intérieur du déclencheur par rapport à la paroi externe (42) d'une face (18) du déclencheur, à laquelle elle est reliée par des parois latérales (43),
- les contacts de la prise sont constitués par des aiguilles de test (3) comportant des extrémités libres effilées,
- les extrémités libres des aiguilles de test sont, en position déconnectée de la prise, logées en totalité à l'intérieur de passages longitudinaux (5) traversant l'élément mobile (1),
- en position connectée de la prise, les extrémités libres des aiguilles de test (3) font saillie à l'extrémité de l'élément mobile (1), traversent les orifices (19) de la paroi complémentaire (17) et viennent en contact, par aboutement, avec les pastilles conductrices (20),
- la prise comporte des moyens de verrouillage coopérant, en position connectée, avec des moyens de verrouillage complémentaires de ladite face du déclencheur.

2. Ensemble selon la revendication 1, caractérisé en ce que ledit épaulement d'appui est constitué par la face supérieure (16) de l'élément mobile, lesdits orifices (19) étant de forme conique, l'extrémité étroite des cônes étant disposée à l'intérieur du déclencheur.

3. Ensemble selon l'une des revendications 1 et 2, caractérisé en ce que l'organe élastique est un ressort de compression (6).

4. Ensemble selon l'une quelconque des revendications 1 à 3, caractérisé en ce que la prise comporte des moyens de limitation du déplacement axial de l'élément mobile (1) vis à vis de l'élément fixe sous l'action de l'organe élastique.

5. Ensemble selon la revendication 4, caractérisé en ce que lesdits moyens de limitation comportent au moins une gorge longitudinale (12) formée dans l'élément mobile (1) et comportant à sa partie inférieure un épaulement (13), un organe de butée complémentaire (14) étant solidaire de l'élément fixe (2).

6. Ensemble selon l'une quelconque des revendications 1 à 5, caractérisé en ce que la partie effilée (25) de l'extrémité libre d'une aiguille de test (3) est solidaire d'un piston (23), le piston étant sollicité par un ressort (24) vers la partie supérieure d'un corps (22) dans lequel il est disposé.

7. Ensemble selon l'une quelconque des revendications 1 à 6, caractérisé en ce que les moyens de verrouillage de la prise comportent au moins un crochet de verrouillage (32) solidaire d'une gaine (27), en matériau isolant, entourant l'élément fixe (2), le crochet et la gaine étant susceptibles d'effectuer une rotation limitée par rapport aux éléments fixe et mobile, une partie (37) du crochet venant, en position de verrouillage, se verrouiller sur un épaulement de verrouillage (41) complémentaire de la face du déclencheur.

8. Ensemble selon la revendication 7, caractérisé en ce que l'élément mobile (1) comporte au moins une gorge (38) de logement du crochet de verrouillage en position déverrouillée.

## Patentansprüche

1. Kontaktvorrichtung mit einem Stecker sowie zugeordneten Verbindungselementen, die dazu dienen, in der Aufsteckstellung mit dem Stecker zusammenzuwirken, wobei der Stecker ein feststehendes Isolierstoffteil (2), zwei am feststehenden Teil (2) befestigte und über ein erstes Ende mit Leitern (10) verbundene Kontakte, ein im Innern des feststehenden Teils (2) axial verschiebbares, bewegliches Isolierstoffteil (1) mit Durchführungsöffnungen (5) für die Kontakte sowie ein elastisches Element umfaßt, welches bestrebt ist, das bewegliche Teil (1) axial aus dem feststehenden Teil (2) herauszudrücken, so daß ein Abschnitt des beweglichen Teils (1) über den Rand des feststehenden Teils (2) hinausragt, wobei das bewegliche Teil (1) einen Auflageabsatz (16) aufweist, der sich in der Aufsteckstellung auf einer zugeordneten Isolierstoffwand (17) abstützt, so daß er das elastische Element (6) zusammendrückt und das bewegliche Teil (1) in das feststehende Teil (2) hineinschiebt,
dadurch gekennzeichnet, daß
- die zugeordneten Verbindungselemente auf einer gedruckten Schaltung (21) ausgebildete leitende Kontaktplättchen (20) umfassen, wobei die gedruckte Schaltung im Innern eines elektronischen Auslösers, hinter der genannten zugeordneten Wand (17) angeordnet ist,
- die Kontaktplättchen (20) als Prüfeingänge dienen und eine Funktionsprüfung des Auslösers ermöglichen, wenn bei aufgesteckter Kontaktvorrichtung eine an die genannten Leiter angeschlossene Energiequelle eine Prüfspannung bzw. einen Prüfstrom liefert,
- die zugeordnete Wand (17) zwei kleine Öffnungen (19) aufweist und bezüglich der eine Seite (18) des Auslösers begrenzenden Außenwand (42), mit der sie über Seitenwände (43) verbunden ist, in Richtung des Auslöserinnenraum zurückversetzt angeordnet ist,
- die Kontaktstifte des Steckers als Prüfnadeln (3) mit freiliegenden verjüngten Enden ausgebildet sind,
- die freiliegenden Enden der Prüfnadeln in der Trennstellung des Steckers vollständig in die das bewegliche Teil (1) durchragenden Längsführungen (5) eingeschoben sind,
- die freiliegenden Enden der Prüfnadeln (3) in der Aufsteckstellung des Steckers über den Rand des beweglichen Teils (1) hervorstehen, die in der zugeordneten Wand (17) ausgebildeten Öffnungen (19) durchragen und die Leiterplättchen (20) durch Auflage kontaktieren,
- der Stecker Verriegelungsmittel umfaßt, die in der Aufsteckstellung mit an der genannten Seite des Auslösers ausgebildeten, zugeordneten Verriegelungsmitteln zusammenwirken.

2. Kontaktvorrichtung nach Anspruch 1, dadurch gekennzeichnet, daß der genannte Auflageabsatz durch die Oberseite (16) des beweglichen Teils gebildet wird, wobei die genannten Öffnungen (19) eine konische Form aufweisen und die Schmalseite der konischen Öffnungen im Innern des Auslösers angeordnet ist.

3. Kontaktvorrichtung nach Anspruch 1 oder 2, dadurch gekennzeichnet, daß das elastische Element eine Druckfeder (6) ist.

4. Kontaktvorrichtung nach irgendeinem der Ansprüche 1 bis 3, dadurch gekennzeichnet, daß der Stecker Mittel zur Begrenzung der durch das elastische Element bewirkten axialen Verschiebung des beweglichen Teils (1) in bezug auf das feststehende Teil umfaßt.

5. Kontaktvorrichtung nach Anspruch 4, dadurch gekennzeichnet, daß die genannten Begrenzungsmittel mindestens eine im beweglichen Teil (1) ausgebildete Längsaussparung (12) umfassen, die in ihrem unteren Bereich einen Absatz (13) aufweist, wobei ein zugeordneter Anschlag (14) am feststehenden Teil (2) befestigt ist.

6. Kontaktvorrichtung nach irgendeinem der Ansprüche 1 bis 5, dadurch gekennzeichnet, daß das freiliegende Ende einer Prüfnadel (3) als fest mit einem Kolben (23) verbundener verjüngter Abschnitt (25) ausgebildet ist, wobei der Kolben (23) durch eine Feder (24) in Richtung des oberen Bereichs einer Hülse (22) beaufschlagt wird, in der er angeordnet ist.

7. Kontaktvorrichtung nach irgendeinem der Ansprüche 1 bis 6, dadurch gekennzeichnet, daß die Verriegelungsmittel des Steckers mindestens einen Verriegelungshaken (32) umfassen, der fest mit einer, das feststehende Teil (2) umschließenden Isolierstoffkappe (27) verbunden ist, wobei der Haken und die Kappe dazu dienen, eine begrenzte Drehung in bezug auf das bewegliche und das feststehende Teil auszuführen, und ein Schenkel (37) des Hakens in der Verriegelungsstellung in eine an der Frontseite des Auslösers ausgebildete, zugeordnete Verriegelungsrast (41) eingreift.

8. Kontaktvorrichtung nach Anspruch 7, dadurch gekennzeichnet, daß das bewegliche Teil (1) mindestens eine Aussparung (38) zur Aufnahme des Verriegelungshakens in der Entriegelungsstellung aufweist.

## Claims

1. A connection assembly comprising a connector and complementary connection elements designed to cooperate with the connector in the connected position, the connector comprising a fixed element (2) made of insulating material, two contacts securedly united to the fixed element (2) and connected via a first end to conductors (10), a movable element (1) made of insulating material comprising passages (5) for the contacts and able to move axially inside the fixed element (2), a flexible part (6) biasing the movable element (1) axially towards the outside of the fixed element (2) so that a part of the movable element (1) protrudes out from the end of the fixed element (2), the movable element (1) comprising a bearing ledge (16) bearing, in the connected position, on a complementary insulating wall (17) so as to compress the elastic part (6) and to move the movable element (1) axially towards the inside of the fixed element (2), an assembly
characterized in that :
- the complementary connection elements comprise conducting pads (20) formed on a printed circuit (21), the printed circuit being arranged inside an electronic trip device, behind said complementary wall (17),
- the pads (20) constitute test inputs enabling the trip device to be tested when, in the connected position of the connection assembly, a power source, connected to said conductors (10), supplies a test voltage or current,
- the complementary wall (17) comprises two fine orifices (19) and is located withdrawn towards the inside of the trip device with respect to the external wall (42) of a face (18) of the trip device, to which it is connected by side walls (43),
- the connector contacts are formed by test needles (3) comprising tapered free ends,
- the free ends of the test needles are, in the disconnected position of the connector, totally housed inside longitudinal passages (5) passing through the movable element (1),
- in the connected position of the connector, the free ends of the test needles (3) protrude out at the end of the movable element (1), pass through the orifices (19) of the complementary wall (17) and come into contact, by abutment, with the conducting pads (20),
- the connector comprises locking means cooperating, in the connected position, with complementary locking means of said face of the trip device.

2. The assembly according to claim 1, characterized in that said bearing ledge is formed by the upper face (16) of the movable element, said orifices (19) being conical in shape, the narrow end of the cones being arranged inside the trip device.

3. The assembly according to one of the claims 1 or 2, characterized in that the flexible part is a compression spring (6).

4. The assembly according to any one of the claims 1 to 3, characterized in that the connector comprises means for limiting the axial movement of the movable element (1) with respect to the fixed element due to the action of the flexible part.

5. The assembly according to claim 4, characterized in that said limiting means comprise at least one longitudinal groove (12) formed in the movable element (1) and comprising at its bottom part a ledge (13), a complementary stop (14) being securedly united to the fixed element (2).

6. The assembly according to any one of the claims 1 to 5, characterized in that the tapered part (25) of the free end of a test needle (3) is securedly united to a piston (23), the piston being biased by a spring (24) towards the upper part of a body (22) in which it is arranged.

7. The assembly according to any one of the claims 1 to 6, characterized in that the locking means of the connector comprise at least one locking hook (32) securedly affixed to a sheath (27), made of insulating material, surrounding the fixed element (2), the hook and sheath being able to perform a limited rotation with respect to the fixed and movable elements, a part (37) of the hook coming and locking, in the locking position, on a complementary locking ledge (41) of the trip device face.

8. The assembly according to claim 7, characterized in that the movable element (1) comprises at least one groove (38) for housing the locking hook in the unlocked position.
